# EUROPÄISCHE PATENTSCHRIFT

(11) **EP 0 782 232 B1**
(45) Veröffentlichungstag und Bekanntmachung des Hinweises auf die Patenterteilung: **15.03.2000**
(21) Anmeldenummer: 96116002.5
(22) Anmeldetag: 05.10.1996
(51) Int. Cl.: H02B 1/46

(54) **Gehäuse aus extrudierten Profilen, insbesondere Aluminiumprofilen**
Housing made of extruded profiles, especially aluminium profiles
Boîtier de profilés métalliques, en particulier de profilés d'aluminium

(30) Priorität: 27.12.1995 DE 29520549 U
(43) Veröffentlichungstag der Anmeldung: 02.07.1997
(73) Patentinhaber: BOPLA GEHÄUSE SYSTEME GmbH, D-32257 Bünde (DE)
(72) Erfinder: Behrendt, Horst, 32584 Löhne (DE)
(74) Vertreter: Thielking, Bodo, Dipl.-Ing.

(56) Entgegenhaltungen:
- DE-U- 8 911 887
- US-A- 4 109 294
- US-A- 4 791 531

## Beschreibung

Die Erfindung betrifft ein Gehäuse aus einem ebenen, extrudierten Profil, insbesondere Aluminiumprofil, mit innenliegenden, zueinander parallel verlaufenden Profilrippen, bei dem das Profil an den Seitenkanten quer zu seiner Längsrichtung und quer zu den Profilrippen abgekantet bzw. abgebogen ist und zumindest teilweise einen Gehäuserahmen bildet.

Bei einem bekannten Gehäuse dieser Art Vgl. DE-U-8 911 887 ist der Gehäuserahmen, der durch Vorder- und Rückwand zu einem Gesamtgehäuse komplettiert werden kann, durch ein einziges Aluminiumprofil mit in Längsrichtung verlaufenden, innenliegenden Rippen gebildet. Die Stoßfuge des Profils liegt dabei in der Gehäuseunterseite.

Diese bekannte Lösung hat den Nachteil, daß es nicht möglich ist, in den Innenquerschnitt zwischen den Profilrippen den Innenquerschnitt völlig ausfüllende Bauteile wie Frontplatten, Leiterplatten od. dgl. in Profil- bzw. Nutrichtung einzuschieben und ohne ergänzende Befestigungsmittel fixiert zu halten.

Es ist weiterhin bekannt, ein annähernd U-förmiges Gehäuseprofil zu extrudieren und das extrudierte Profil auf der offenen Seite mit einer ebenen Platte zu einem Gehäuserahmen zu komplettieren (US 4,109,294 A und US 4,791,531). Bei diesen Lösungen erstrecken sich die Profilrippen und die zwischen den Profilrippen gebildeten Profilnuten auf lediglich zwei einander gegenüberliegenden Seiten des U-förmigen Gehäuserahmenteils parallel zu der ebenen Platte, welche den Gehäuserahmen komplettiert.

Bei einer derartigen Lösung müssen die zur Vervollständigung eines Gehäuses erforderlichen frontseitigen und rückseitigen Platten mit Befestigungsschrauben an den Stirnseiten der U-förmigen Profilteile befestigt werden. Plattenförmige Einbauteile können nur entlang zweier einander gegenüberliegender Seitenkanten im Gehäuse gehalten werden.

Ausgehend von dem eingangs erwähnten Stand der Technik liegt der Erfindung die Aufgabe zugrunde, ein Gehäuse der als bekannt vorausgesetzten Art so auszubilden, daß es einen Einschub von insbesondere plattenförmigen Bauteilen wie Frontplatten, Leiterplatten od. dgl. zwischen benachbarten Profilrippen ermöglicht, wobei diese Bauteile den von den Profilnuten gegebenen lichten Querschnitt im wesentlichen ausfüllen und wobei diese plattenförmigen Bauteile an allen vier Rändern im Gehäuse gehalten werden.

Die Lösung dieser Aufgabe erfolgt erfindungsgemäß dadurch, daß der Gehäuserahmen aus einem drei Seiten aufweisenden Rahmenstück und einem zusätzlichen ebenen Rahmenstück zusammengesetzt ist, wobei das zusätzliche ebene Rahmenstück die gleiche Profilierung aufweist wie das die drei Seiten aufweisende Rahmenstück. Dabei erweist es sich als zweckmäßig, daß das Rahmenstück etwa U-förmig ausgebildet ist.

Bei einer weiteren bevorzugten Ausführungsform sind die Profilrippen im Bereich der Seitenkanten zumindest teilweise abgetragen.

Das erfindungsgemäße Gehäuse ermöglicht es, von der offenen Seite des drei Seiten aufweisenden Rahmenstücks her plattenförmige Bauteile vollflächig in die zwischen den Profilrippen gebildeten Profilnuten einzuschieben und sie ringsum an allen Rändern im Einbauzustand zu sichern. Die Abtragung der Profilrippen im Bereich der Seitenkanten, also an den Abkantbereichen, ermöglicht eine einwandfreie Abkantung auch bei vergleichsweise hohen Profilrippen.

Nachstehend wird eine bevorzugte Ausführungsform der Erfindung anhand der Zeichnung im einzelnen beschrieben. Es zeigen:

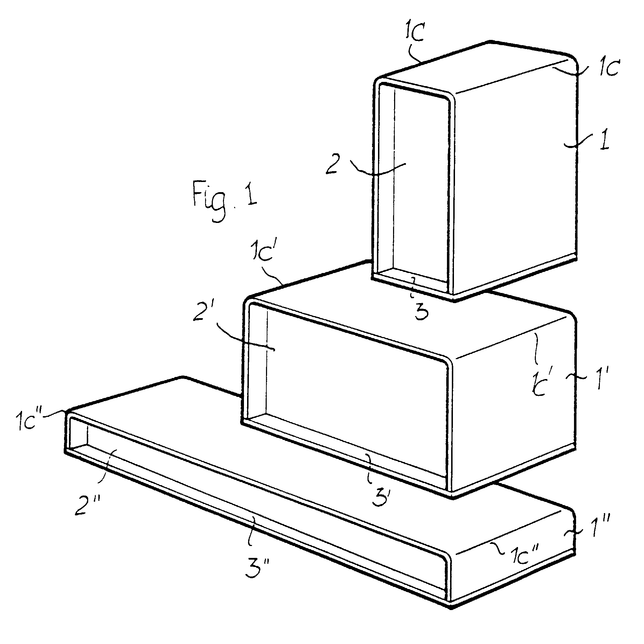

- Figur 1 -: drei in ihrem Aufbau gleiche und in ihrer Form unterschiedliche Gehäuse in perspektivischer Darstellung,
- Figur 2 -: eine teilweise Darstellung eines ebenen Aluminiumprofils mit abgetragenen Bereichen der Profilrippen,
- Figur 2a -: eine Ansicht auf das ebene Aluminiumprofil in Richtung des Pfeils IIa gemäß Figur 2,
- Figur 2b -: eine Ansicht in Richtung des Pfeils IIa gemäß Figur 2 auf das Aluminiumprofil nach dem Abkantvorgang,
- Figur 3 -: eine perspektivische Darstellung eines die Unterseite des Gehäuses bildenden ebenen Rahmenstücks,
- Figur 3a -: eine Ansicht gemäß Pfeil IIIa in Figur 3,
- Figur 4 -: eine perspektivische Darstellung eines Gehäuses mit pultartiger Grundform.

In den unterschiedlichen Ausführungsformen sind gleiche oder einander entsprechende Teile jeweils mit den gleichen Bezugszeichen bezeichnet. Sie unterscheiden sich lediglich durch eine unterschiedliche Anzahl von Hochstrichen voneinander.

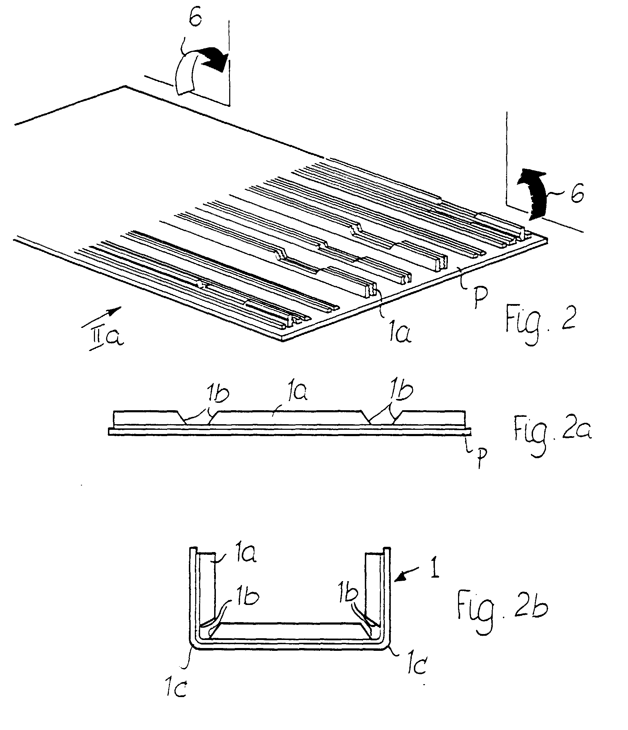

Das in Figur 2 dargestellte ebene Aluminiumprofil P besitzt in Extrusionsrichtung verlaufende Profilrippen 1a. In Figur 2 sind die Profilrippen nicht über die gesamte Länge des Aluminiumprofils verlaufend gezeichnet, sie erstrecken sich aber praktisch über die gesamte Länge.

Die Profilrippen 1a sind im Bereich der beim Abkanten gebildeten Seitenkanten 1c über den größten Bereich ihrer Gesamthöhe abgetragen, so daß sich Flanken 1b ergeben, die einen Ausschnitt seitlich begrenzen. Die Flanken 1b halten auch nach dem Abkanten, welches durch die gegenläufigen Pfeile 6 in Figur 2 symbolisiert wird, einen Abstand voneinander.

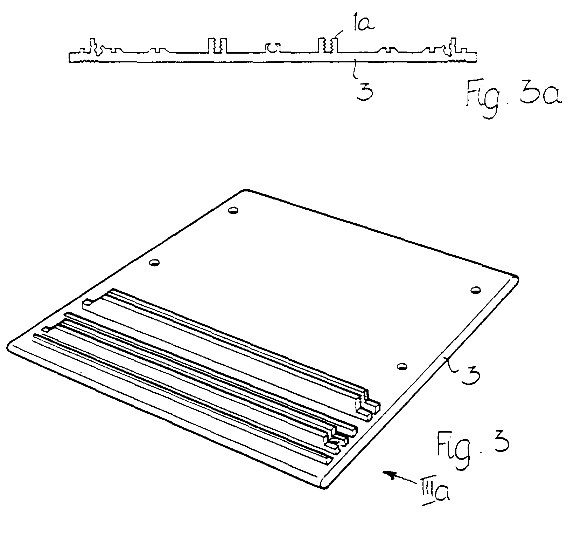

Figur 3 zeigt die perspektivische Darstellung eines ebenen extrudierten Profils, welches das zusätzliche Rahmenstück 3 des Gehäuserahmens bildet. Dieses ebene Rahmenstück ist in Figur 3 nur teilweise, in Figur 3a hingegen vollständig gezeichnet.

Das Profil des Rahmenstücks 1 entspricht dem Profil des ebenen Rahmenstücks 3.

Plattenförmige Elemente, beispielsweise Frontplatten 2, können durch die Unterseite des Rahmenstücks 1 zwischen benachbarte Profilrippen la eingeschoben werden und in ihrer Einschublage durch das ebene Rahmenstück 3 gehalten werden, wenn der Gehäuserahmen komplettiert ist.

Sowohl das ebene als auch das U-förmige Rahmenstück weisen Profilrippen auf, die nicht bis zur Stirnkante durchgeführt sind, sondern gegenüber dem Stirnkantenbereich zurückspringen. Hierdurch wird ein dichtes Zusammensetzen des Gehäuserahmens aus dem drei Seiten aufweisenden Rahmenstück 1 und dem ebenen Rahmenstück 3 möglich.

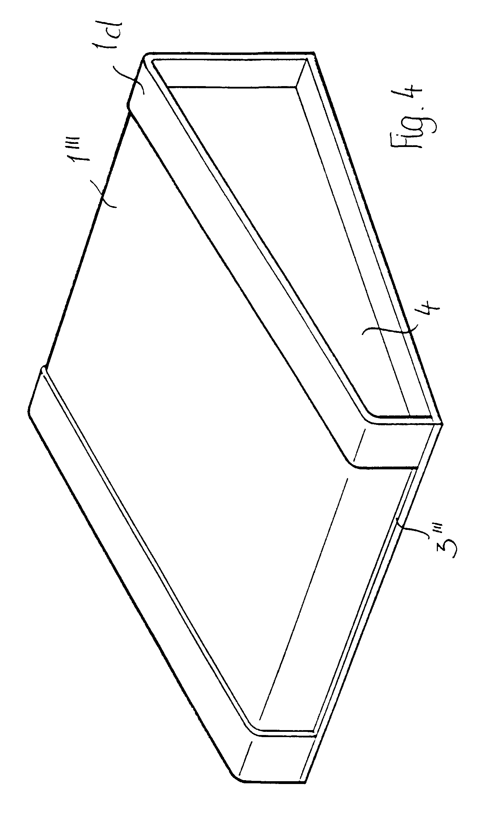

In Figur 4 ist eine Ausführungsform gezeigt, bei der das Rahmenstück 1''' zwar ebenfalls annähernd U-förmig ausgebildet ist, bei diesem Rahmenstück weisen die Schenkel des U jedoch unterschiedliche Längen auf, mit der Folge, daß ein pultförmiges Gehäuse entsteht, dessen Gehäuserahmen 1''' durch ein ebenes Rahmenstück 3''' komplettiert wird. Bei der Ausführungsform gemäß Figur 4 weist das Profil an seinen Randbereichen auch auf seiner Außenseite eine laschenartige Profilierung ld auf. Das plattenförmige Einschubteil befindet sich bei dieser Ausführungsform an den Seitenwänden.

## Patentansprüche

1. Gehäuse aus einem ebenen, extrudierten Profil, insbesondere Aluminiumprofil, mit innenliegenden, zueinander parallel verlaufenden Profilrippen (1a), bei dem das Profil an den Seitenkanten (1c) quer zu seiner Längsrichtung und quer zu den Profilrippen (1a) abgekantet bzw. abgebogen ist und zumindest teilweise einen Gehäuserahmen bildet,
dadurch gekennzeichnet,
daß der Gehäuserahmen aus einem drei Seiten aufweisenden Rahmenstück (1; 1'; 1''; 1''') und einem zusätzlichen ebenen Rahmenstück (3; 3'; 3''; 3''') zusammengesetzt ist, wobei das zusätzliche ebene Rahmenstück (3; 3'; 3''; 3''') die gleiche Profilierung aufweist wie das die drei Seiten aufweisende Rahmenstück (1; 1'; 1''; 1"').

2. Gehäuse nach Anspruch 1,
dadurch gekennzeichnet,
daß das Rahmenstück (1; 1'; 1''; 1''') etwa U-förmig ausgebildet ist.

3. Gehäuse nach Anspruch 1 oder 2,
dadurch gekennzeichnet,
daß die Profilrippen (1a) im Bereich der Seitenkanten (1c) zumindest teilweise abgetragen sind.

## Claims

1. Housing of a planar, extruded section, especially aluminium section, with internal profile ribs (1a) extending parallel to each other, in which the section is bent or curved at the side edges (1c) transverse to its longitudinal direction and transverse to the profile ribs (1a) and forms at least partially a housing frame,
characterised in that
the housing frame is put together from a frame piece (1; 1'; 1''; 1''') and an additional planar frame piece (3; 3'; 3'''; 3'''), wherein the additional planar frame piece (3; 3'; 3''; 3"') has the same profiling as the frame piece (1; 1'; 1''; 1''') which has the three sides.

2. Housing according to Claim 1,
characterised in that
the frame piece (1; 1'; 1''; 1''') is formed generally in a U-shape.

3. Housing according to Claim 1 or 2,
characterised in that
the profile ribs (1a) are at least partially taken away in the region of the side edges (1c).

## Revendications

1. Boîtier en profilé extrudé, notamment en profilé d'aluminium, avec des nervures profilées (1a), disposées à l'intérieur et s'étendant parallèlement les unes par rapport aux autres, le profilé étant plié ou coudé dans les zones (1c) des bords latéraux, transversalement par rapport au sens de sa longueur et transversalement par rapport aux nervures profilées (1a) et formant, au moins partiellement, un cadre de boîtier,
caractérisé en ce que
le cadre du boîtier est composé d'une pièce (1; 1'; 1''; 1''') qui est pourvue de trois côtés et d'une pièce supplémentaire, plane (3; 3'; 3"; 3 "') qui présente le même profilage que la pièce (1; 1'; 1''; 1''') pourvue de trois côtés.

2. Boîtier selon revendication 1,
caractérisé en ce que
la pièce (1; 1'; 1''; 1''') est conçue approximativement en U.

3. Boîtier selon la revendication 1 ou 2,
caractérisé en ce que
les nervures profilées (1a) sont évidées, au moins partiellement, dans la zone (1c) des bords latéraux (1c).
